# EUROPEAN PATENT APPLICATION

(11) **EP 2 001 275 A1**
(43) Date of publication of application: **10.12.2008**
(21) Application number: 07109833.9
(22) Date of filing: 07.06.2007
(51) Int. Cl.: H05K 13/02

(54) **Apparatus and method for separating electronic components**

(71) Applicant: ISMECA Semiconductor Holding SA, 2300 La Chaux-de-Fonds (CH)
(72) Inventor: Gonzalez Miguel, 2300 La Chaux-de-Fonds (CH); Cretenet, Davy, 25650 La Chaux-de-Gilley (FR)
(74) Representative: P&TS Patents & Technology Surveys SA

(57) **Abstract**

An apparatus for isolating electronic components, comprising:
a feeder for moving a row of electronic components (6) to be isolated along a path,
an abutment (71) at the end of said path, arranged for preventing displacement of the leading component in said row further than a predefined abutment position,
a movable stop element (72, 74) at a fixed position along said path, for separating the leading component on one side of said stop element from all the components on the other side of said stop element,
a carriage (70) for translating the electronic component (6) separated by said stop element (72, 74) at a predefined removal position where it can be gripped.

## Description

### Field of the invention

The present invention concerns an apparatus and a method for separating electronic components such as integrated circuits that are delivered in succession by a feeder.

### Description of related art

When handling electronic components, it is often necessary to singulate the individual successive components that need to be tested, packaged or mounted. This task is especially difficult when the components are delivered in bulk.

US993588 describes an apparatus for separating electronic components or other objects and comprising a stop element arranged so as to retain the leading one of the objects. The isolated object slides down on a slope and abuts against a stop piece at a position where it can be gripped. As the isolated element is only accelerated by gravity, the handling speed of this apparatus is limited. Moreover, the centre of the isolated object is not precisely defined and depends among other on its length, so that aspiration of the object by a suction head may be difficult.

DE3531120 describes another device for the sorting of integrated circuit based on gravity.

DE3638430 discloses an apparatus for separating electronic components in which separation occurs so that the foremost component of a delivery row is removed with the aid of a gripping device. The components are not clearly separated so that the gripping device does not always grip a single component.

### Brief summary of the invention

An aim of the invention is therefore to propose a new apparatus which solves at least some problems of the prior art.

According to the invention, these aims are achieved by means of an apparatus comprising the features of the independent claims, preferred embodiments being indicated in the dependent claims and in the description.

Those aims are also achieved by means of an apparatus comprising:
a feeder for feeding successive electronic components to be isolated along a path,
abutments at the end of said path, arranged for preventing displacement of said components further than a predefined abutment position,
a movable stop element at a fixed position along said path, for isolating the leading component on one side of said stop element from all the components on the other side of said stop element,
a carriage for translating the electronic component(s) isolated by said stop element at a predefined removal from position where it can be removed.

This has the advantage that adaptation to components with different lengths only requires a displacement of the abutment and/or adjustment of the travelling length of the carriage. There is no need for displacing the stop element itself.

In a preferred embodiment, the stop element and the carriage are actuated by two independent actuators, for example two different motors. This has the advantage that the choice, and the command, of each motor may be optimized to the two different functions.

According to the invention, a new apparatus and a new method for separating electronic components are proposed in which:
- The width and/or the height of the tunnel in the linear feeder may be adjusted
- The stop element and the sliding device used for separating and transporting the leading electronic components in a row which are actuated by two independent actuators
- The stroke of the carriage, and the size of an abutment on this carriage, may be adjusted to the length of the electronic component

Those three features are independent of each other and may be combined or applied separately.

### Brief Description of the Drawings

The invention will be better understood with the aid of the description of an embodiment given by way of example and illustrated by the figures, in which:
Fig. 1 shows a perspective view of a system incorporating the apparatus of the present invention.
Fig. 2 shows a perspective view of a detail of the system of Fig. 1, illustrating the end of the feeder and the apparatus of the present invention.
Fig. 3 is another perspective view over the elements of Fig. 2
Fig. 4 is a perspective view of a variant embodiment of the apparatus of the invention.
Fig. 5 is a side view of the apparatus of Fig. 4.
Figs. 6-10 are side view schematically illustrating various steps of the separation process.

### Detailed Description of possible embodiments of the Invention

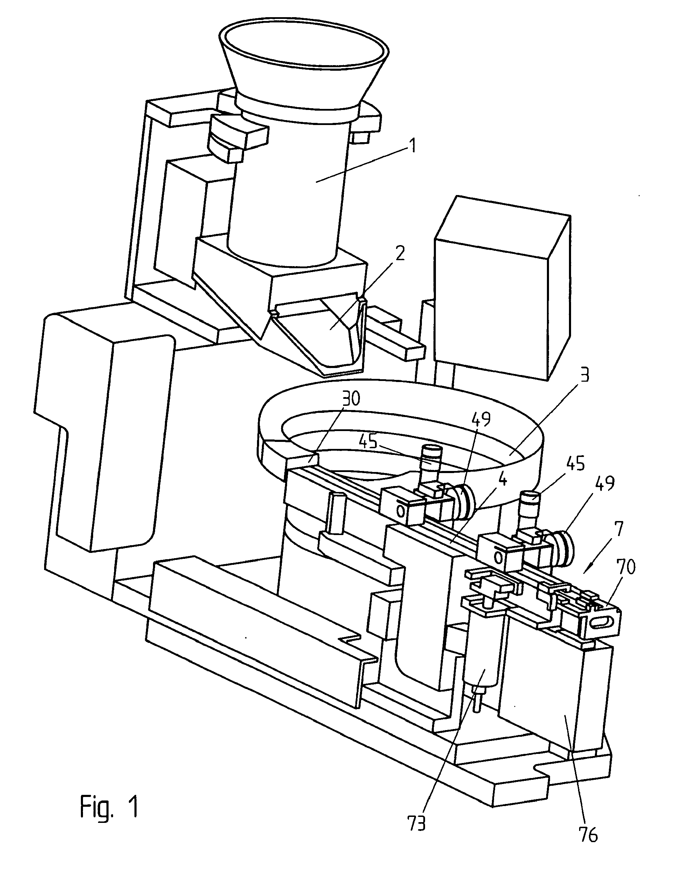

Fig. 1 illustrates an example of system incorporating an apparatus according to the present invention. The system comprises a vertical tube 1 with an upper opening into which electronic components, for example integrated circuits, may be introduced in bulk. The components fell by gravity on a dispensing funnel 2 and into a vibratory feeder bowl 3. The bowl comprises a central receiving section for receiving components from the funnel, and a ramp-like track along which the electronic components flow to a discharge 30 and into a feeder track 4. Vibratory bowls for delivering electronic components to a feeder are known in the art.

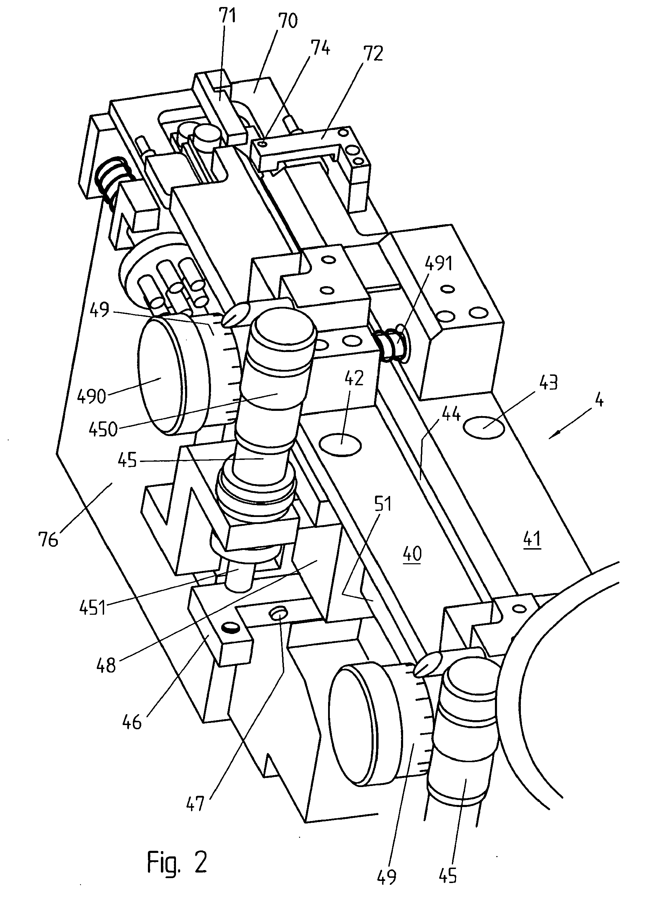

The linear feeder track 4 comprises a flat base 51 (Fig. 2) and a cover made up of two longitudinal L-shaped parts 40, 41 separated by a longitudinal slit 44. The two cover parts thus define two vertical walls for guiding the component. In another embodiment, the cover is made up of flat parts and the base is U-shaped. The cover comprises adjusting elements for adjusting the width and/or the height of the tunnel between the base 51 and the cover, depending on the width and height of the electronic components to be transported. In another embodiment, it could be possible to adjust the width of the base in order to adapt it to different components.

In the feeder 4, the electronic components are moved from the bowl 3 to the isolating apparatus using any suitable means, preferably by vibrations generated by a vibratory motor (not shown), and/or, by gravity and/or by an air flow. In this latter case, the air flow is preferably pulsed, possibly with a sinus or saw shaped variation of the air speed, so as to prevent jamming and to control the moving speed of the components in the track feeder.

The adjusting elements for adjusting the height of the tunnel through the feeder 4 comprise in the illustrated embodiment two longitudinally spaced, vertical precision depth gages 45 for adjusting the vertical distance between the cover 40, 41 and the base 51. The depth gages 45 are used for adjusting the height of the tunnel in the feeder track 4.

Each depth gage 45 comprises a rotating head 450 that can be screwed into a fixed base for adjusting the penetration depth of a plunger part 451. The plunger 451 pushes down a pivoting arm 46 against the force of a spring (not shown), so as to pivot the arm 46 around the fixed axis 47 and to raise the opposite end of the arm 46 together with the cover support 48. The flat base 51 remains immobile. In a variant embodiment, the base is vertically moved while the cover remains in a fixed vertical position. The operator can preferably check a marking (not shown) on the head 450 to ensure equivalent adjustment of both adjustment elements 45.

Two horizontal adjusting elements 49 are also provided for adjusting the width of the slit 44. Each element comprises a head 490 unitary with a plungers 491. The plungers 491 are provided with left and right screws in order to move in a symmetric movement both cover parts 40 and 41, so as to center the slid 44.

Each cover part 40 and 41 comprises magnets 42 and 43 respectively exert an attraction toward the basis 48, so as to bring the cover 40, 41 and the base 51 close together and allow the cover parts 40 and 41 to slide laterally for width adjustment. The lower face (not shown) of the cover parts 40, 41 may comprise longitudinal ribs for guiding the components during their displacement in the tunnel.

The manual adjusting elements 45, 49 can also be replaced by motorized adjusting elements in order to adapt the width and/or height of the tunnel in the linear feeder under the control of a digital control system.

A stop element 72 is provided close to the extremity of the feeder 4 opposite to the bowl 3. The stop element 72 is movable in a direction substantially transverse to the displacement direction of the components in the feeder track 4, for separating the leading component from all other components in the row. In a preferred embodiment, the stop element comprises an interchangeable pin 74, or an equivalent element such as a blade, that can be movably engaged in the slit 44 for pressing on the upper face of the second component in the row, thus preventing its further move while the leading component is removed. In a various embodiment, the pin or equivalent stop element is engaged between the first and the second element.,. The shape and length of the pin may be adapted to the shape and size of the electronic components to separate. The longitudinal position of the stop element 72 along the feeder is fixed and does not need to be changed, even if the components with a different length are transported.

In a further embodiment, the stop element 72 comprises a controlled vacuum nozzle, or other pneumatic means near the end of the track feeder, for blocking and releasing the component near the nozzle.

The stop element 72 is actuated by a motor, for example a rotating brushless motor, for example over a cam or another eccentric element that converts the rotation of the motor into a periodic series of linear ascending and descending movement of the pin 74. The duration of the period between two displacements of the pin is preferably short to ensure that even contiguous successive components will be separated.

In another embodiment, the displacements of the stop element 72 are controlled by an electro-optical sensor 75 detecting the arrival of a component in the dead spot area 77. This solution has the advantage that the displacements of the stop element 72 may be better synchronized with the translation of the components, so as to ensure that the stop element will always contact a same portion of the component, for example close to its middle.

After being released by the stop element 72, the leading electronic component is moved further until it abuts against an abutment 71 that prevents its further displacement. The abutment 71 is adjustable or interchangeable so that its length may be adapted to the length of the components, as will be seen.

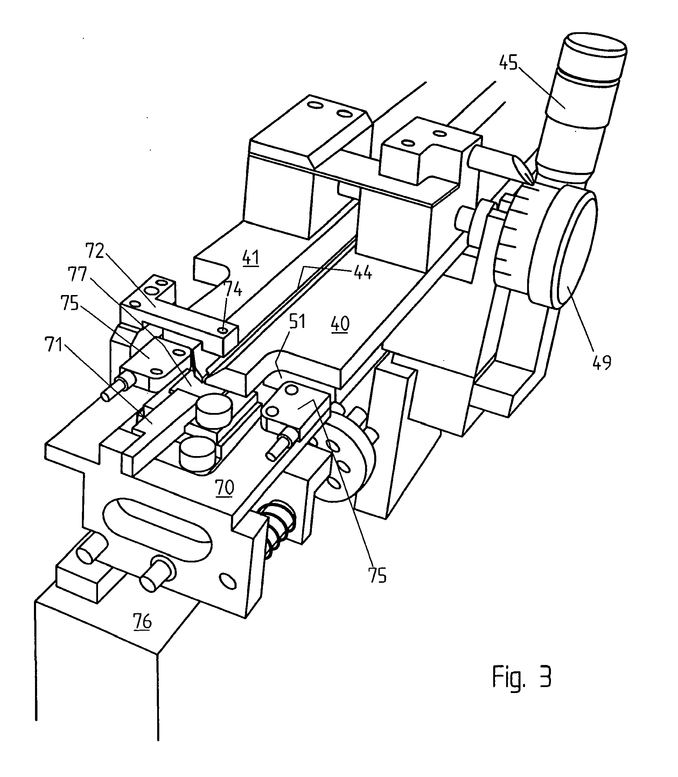

A pair of cooperating optical sensors 75 detects the arrival of a component on the dead spot area 77 adjacent to the abutment 71, and initiates the translation of a carriage 70 supporting the dead spot 77. The carriage 70 is actuated by a transducer independent of the transducer used for moving the stop element 72. In the preferred embodiment illustrated on Figures 1 to 3, the carriage 70 is moved by a linear transducer 76, preferably a voice coil linear transducer based on a moving coil displaced in the magnetic field of a permanent magnet structure. The length of the stroke may be adapted to the length of the electronic component by changing the control signals applied to the voice coil.

The carriage 70 linearly moves the singulated leading component to a removal place where it can be gripped by a gripping device (not shown), for example a suction based gripping device. In an embodiment, the gripping device is a part of a turret that moves the components between a plurality of test and handling stations at the periphery.

The two independent actuators used for actuating the stop element 72 and the carriage 70 are preferably controlled by a numerical control system that executes a program and receives instruction from the operator as well as feedback signal provided, amongst other, by electro-optical sensors 75 and other sensors along the path followed by the components.

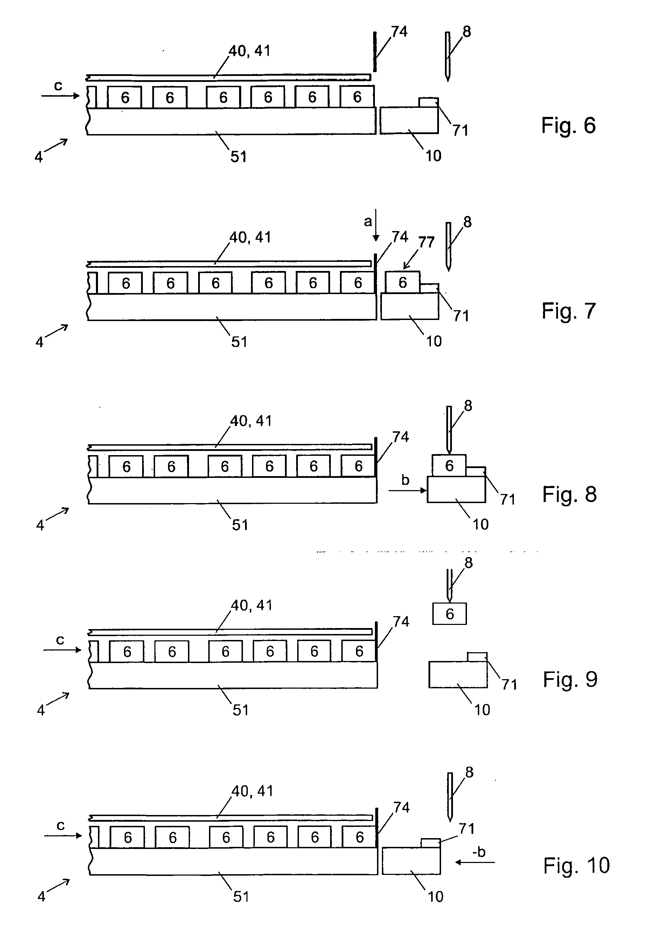

The length of the interchangeable abutment and the stroke of the carriage 70 are adapted to the length of the electronic components in order to move the middle of the upper face of the component just under the nozzle of the suction device. The displacements of the components are schematically illustrated on Figures 6 to 10.

The figure 6 is a schematic side view of a feeder 4 comprising a base and a cover 40 41. A row of unevenly spaced electronic components 6 is moved in the direction of the arrow c in the tunnel between the base and the cover 40, 41. On Figure 7, the leading component 6 reaches the dead spot 77 contiguous to the abutment 71 on the carriage 70. The stop element 74 is moved by its own actuator in a direction transverse to c, so as to block the next component in the row.

On Figure 8, the carriage is moved in the direction of arrow b (parallel to c) until it reaches a position where the component 6 is longitudinally centred under the vacuum gripping device 8. The position of the component depends both on the length of the abutment 71 and on the length of the displacement of the element 70.

On Figure 9, the leading component 6 is removed from the dead spot 77 by the gripping device 8. Removal is detected by the optical sensors 75, and triggers the return of the carriage to the initial position adjacent to the feeder 4 (Figure 10). The stop element is then independently moved up, and the next component can be moved to the dead spot 77 for the next cycle.

The adaptation of the apparatus to electronic components of different length is thus made primarily by changing the stroke of the carriage 70. If the component is very long, it may furthermore be necessary to replace the abutment 71 by a shorter one, in order to avoid the risk that the rear part of the leading component extends under the stop element 72. It is not necessary however to adapt or move the stop element itself.

Electronic components of different width and height only require an adjustment of the cover parts 40, 41 of the feeder 4, and possibly an exchange of the pin 74 in the stop element.

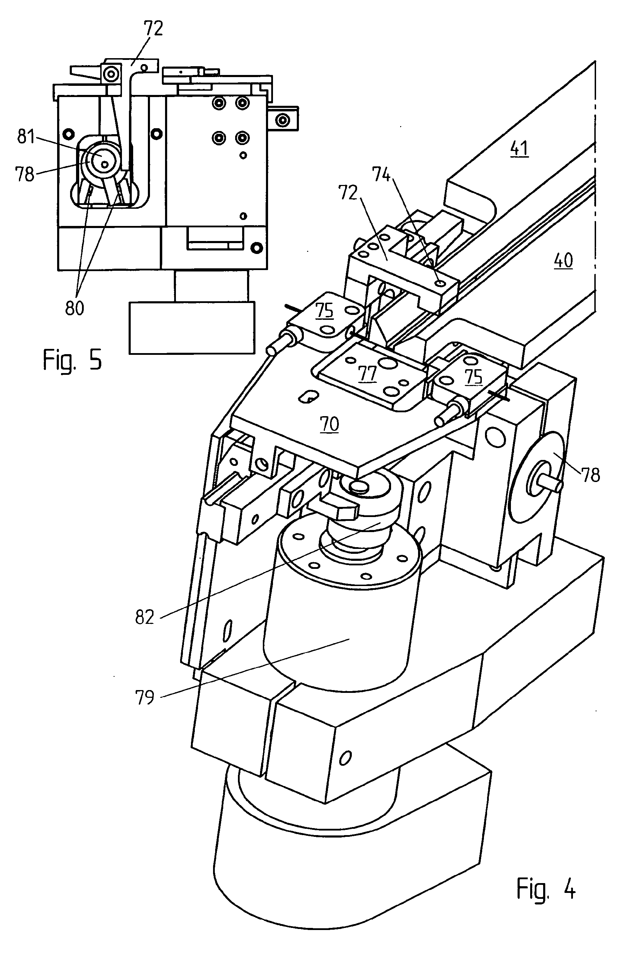

A further embodiment of the isolating apparatus is illustrated on Figures 4 and 5. In this embodiment, the linear displacement of the sliding carriage 70 is actuated by a rotary motor 79 over an eccentric part 82, whereas the actuation of the stop element 72 is independently actuated by a different rotary motor 78 that drives a second eccentric part 81. Two sensors 80 limit the travel of the rotary 78 and initiate reversal of the sense of rotation. The eccentric part 81 directly acts on a portion of the stop element for periodically closing and opening it. The rotation speed of the motor 72 may be adapted to the length of the components and to their speed of displacement in the feeder 4.It is also possible to replace the eccentric part 82 and to adapt it to various components.

### List of parts

| | |
|---|---|
| 1 | Feeding tube |
| 2 | Funnel |
| 3 | Vibratory feeder bowl |
| 30 | Discharge |
| 4 | Track feeder |
| 40 | Left feeder cover |
| 41 | Right feeder cover |
| 42 | Left magnet |
| 43 | Right magnet |
| 44 | Longitudinal slit |
| 45 | Depth gage |
| 450 | Head |
| 451 | Plunger |
| 46 | Pivoting arm |
| 47 | Axis |
| 48 | U-Frame |
| 49 | Width adjusting element |
| 490 | Head |
| 491 | Plunger |
| 51 | Base of the feeder 4 (track) |
| 6 | Component |
| 7 | Isolating apparatus with linear motor |
| 70 | Carriage |
| 71 | Abutment |
| 72 | Stop element (comprises a pin, or a blade, or a vacuum nozzle,..) |
| 73 | Rotating motor for actuating the stop element |
| 74 | Pin |
| 75 | Optoelectronic detector |
| 76 | Voice coil motor |
| 77 | Dead spot |
| 78 | Rotating motor for actuating the stop element |
| 79 | Rotating motor for actuating the car |
| 80 | Contactors |
| 81 | Eccentric |
| 82 | Eccentric |

## Claims

1. An apparatus for isolating electronic components, comprising:
a feeder (4) for moving a row of electronic components (6) to be isolated along a path,
an abutment (71) at the end of said path, arranged for preventing displacement of the leading component in said row further than a predefined abutment position,
a motorized stop element (72, 74) at a fixed position along said path for separating the leading component on one side of said stop element from all the components on the other side of said stop element,
a carriage (70) for translating the electronic component (6) separated by said stop element (72, 74) at a predefined removal position where it can be gripped.

2. The apparatus of claim 1, comprising a first actuator for actuating said stop element (78) and a second distinct actuator (76, 79) for actuating said carriage (70).

3. The apparatus of claim 2, wherein said first actuator comprises a rotating brushless motor (78) for rotating an eccentric element (81) so as to stop and free displacements of the components along said path at each turn.

4. The apparatus of one of the claims 2 or 3, wherein said second actuator comprises a linear voice coil (76).

5. The apparatus of one of the claims 2 to 4, wherein the stroke of displacement of said carriage (70) is adaptable to the length of the electronic components to separate.

6. The apparatus of one of the claims 2 to 5, wherein the stroke of displacement of said carriage is electronically controllable with signals applied to said second actuator (76, 79).

7. The apparatus of one said claims 1 to 6, wherein said abutment (71) is mounted on said carriage (70).

8. The apparatus of one said claims 1 to 7, wherein said abutment (71) is interchangeable or adjustable in order to adapt it to the length of said electronic component (6).

9. The apparatus of one of the claims 1 to 6, further comprising a gripping device (8), for example a suction gripping device, for removing said electronic component (6) from said removal position.

10. The apparatus of claim 9, wherein the displacement range of said carriage (70) is electronically controlled so at to centre the isolated electronic component (6) under said gripping device.

11. The apparatus of one of the claims 1 to 10, wherein said feeder (4) comprises a base (51) and a cover (40, 41) above said feeder, said electronic components (6) circulating between said base (51) and said cover, the height of the tunnel between said base and said cover being adaptable to the height of different electronic components.

12. The apparatus of claim 11, comprising permanent magnets (42, 43) for maintaining the parallelism between said base (51) and said cover (40, 41).

13. The apparatus of claim 12, comprising screws (45) on one side of said cover for adapting said height, said magnets (42, 43) being arranged so as to exert a force for attracting said cover (40, 41) toward said base (51).

14. The apparatus of one of the claims 11 to 13, said cover two cover parts (40, 41) separated by a longitudinal slit (44), wherein the width of said slit is adaptable to the width of said electronic components.

15. A method for isolating electronic components, comprising the steps of:
moving a row of electronic components (6) to be isolated along a path,
preventing displacement of the leading component in said row further than a predefined abutment position,
actuating a movable stop element (72, 74) at a fixed position along said path for separating the leading component on one side of said stop element from all the components on the other side of said stop element,
translating the leading electronic component (6) separated by said stop element (72, 74) at a predefined removal position,
gripping the translated electronic component with a gripping device.

16. The method of claim 15, further comprising the step of replacing an abutment for adjusting the position of said electronic component at said removal position.

17. The method of one of the claims 15 or 16, further comprising the step of adapting the travel length of said electronic component during its translation.
